# EUROPÄISCHE PATENTANMELDUNG

(11) **EP 4 472 371 A1**
(43) Veröffentlichungstag der Anmeldung: **04.12.2024**
(21) Anmeldenummer: 24175644.4
(22) Anmeldetag: 14.05.2024
(51) Int. Cl.: H05K 7/14, H02M 7/00, H01R 43/02

(54) **PULSWECHSELRICHTER SOWIE LEISTUNGSMODUL FÜR EINEN SOLCHEN PULSWECHSELRICHTER**

(30) Priorität: 01.06.2023 DE 102023114477
(71) Anmelder: AUDI AG, 85057 Ingolstadt (DE); VOLKSWAGEN AG, 38440 Wolfsburg (DE)
(72) Erfinder: Zachariae, Jan, 38108 Braunschweig (DE); Maznov, Viktor, 34298 Eschenstruth (DE); Amecke, Holger, 38108 Braunschweig (DE); Ruppert, Daniel, 85101 Lenting (DE)
(74) Vertreter: Bierschneider, Walter

(57) **Zusammenfassung**

Die Erfindung betrifft ein Pulswechselrichter sowie ein Leistungsmodul (5) für einen solchen Pulswechselrichter. Das Leistungsmodul (5) weist einen Hartverguß-Körper (7) auf, in dem die Leistungsmodul-Lasche (11) eingegossen ist, die mit einer zu einem Zwischenkreiskondensator (3) führenden Lasche (19, 39) in Überlapp-Schweißverbindung bringbar ist. Erfindungsgemäß ist die Leistungsmodul-Lasche (11) an ihrer, der Lasche (19, 39) gegenüberliegenden Seite auf einem tragenden Hartverguß-Material des Hartverguß-Körpers (7) abgestützt, das im Schweißprozess als Gegenhalter (27) wirkt.

## Beschreibung

Die Erfindung betrifft einen Pulswechselrichter für eine Antriebseinheit eines elektrisch betriebenen Fahrzeugs nach dem Oberbegriff des Anspruches 1 sowie ein Leistungsmodul für einen solchen Pulswechselrichter nach Anspruch 10.

Die elektrische Antriebseinheit eines elektrisch betriebenen Fahrzeugs weist einen Pulswechselrichter auf, dessen Leistungsmodule mit ihren DC-Anschlüssen an einem Zwischenkreiskondensator angeschlossen sind, und mit ihren AC-Anschlüssen über eine AC-Strombrücke an die Elektromaschine der Antriebseinheit angeschlossen sind.

Ein gattungsgemäßer Pulswechselrichter ist aus einem Montageträger aufgebaut, an dem der Zwischenkreiskondensator und zumindest ein Leistungsmodul befestigt sind, die mit ihren Kontaktlaschen in einer Überlapp-Schweißverbindung sind. Das Leistungsmodul ist mit einem Hartverguß-Körper ausgebildet, in dem die Leistungsmodul-Lasche eingegossen ist. Ein derart aufgebauter Pulswechselrichter ist mit den folgenden Prozessschritten herstellbar: Zunächst wird in einem Vormontageschritt der Zwischenkreiskondensator und das Leistungsmodul am Montageträger vormontiert. Anschließend folgt ein Schweißschritt, in dem die einander überlappenden Kontaktlaschen mit einem Niederhalter unter Bildung eines Nullspalts auf einen Gegenhalter pressbar und anschließend miteinander verschweißbar sind.

Das hierzu erforderliche Schweißwerkzeug weist im Stand der Technik bauteilaufwändig einen separaten Gegenhalter auf, auf dem die beiden zu verschweißenden Kontaktlaschen von Zwischenkreiskondensator und Leistungsmodul ?.

Aus der US 2017/0033704 A1 ist eine elektronische Vorrichtung für einen elektrischen Antriebsstrang eines Fahrzeugs bekannt. Die Vorrichtung umfasst eine Leistungsmodulanordnung mit einem Gehäuse, das eine erste Seite definiert, und einer Anordnung von Leistungsmodulen, die innerhalb des Gehäuses angeordnet sind. Jedes der Leistungsmodule umfasst erste elektrische Kontaktflächen, die zumindest teilweise in die erste Seite eingebettet sind und eine Befestigungsfläche aufweisen, die im Wesentlichen parallel zu der ersten Seite verläuft. Eine Kondensatorbaugruppe umfasst ein Gehäuse, das eine zweite Seite definiert, die im Wesentlichen eine zweite Seite definiert, die im Wesentlichen koplanar mit der ersten Seite ist, und eine Anordnung von zweiten elektrischen Kontakt-Terminals, die zumindest teilweise in die zweite Seite eingebettet sind. Die zweiten elektrischen Kontakt-Terminals haben eine Befestigungsfläche, die im Wesentlichen parallel zur zweiten Seite verläuft. Eine Stromschiene koppelt mechanisch und elektrisch mindestens eines der ersten Kontaktfelder mit mindestens einem der zweiten Kontaktfelder.

Aus der US 2018/0206359 A1 ist ein Leistungsmodul bekannt, das ein Leistungssubstrat, ein auf dem Leistungssubstrat angeordnetes Gehäuse und einen mit dem Leistungssubstrat elektrisch verbundenen ersten Anschluss aufweist. Der erste Anschluss umfasst eine Kontaktfläche, die sich oberhalb des Gehäuses auf einem ersten Höheniveau befindet. Das Leistungsmodul umfasst zudem einen zweiten Anschluss mit eine Kontaktfläche, die sich oberhalb des Gehäuses auf einem zweiten Höhenniveau befindet, das sich vom ersten Höheniveau unterscheidet. Zudem ist ein dritter Anschluss bereitgestellt, der elektrisch mit dem Leistungssubstrat verbunden ist.

Die Aufgabe der Erfindung besteht darin, einen Pulswechselrichter bereitzustellen, der im Vergleich zum Stand der Technik fertigungstechnisch einfacher herstellbar ist, und/oder im Vergleich zum Stand der Technik eine reduzierte Streuinduktivität sowie ausreichende Luft-/Kriechstrecken aufweist.

Die Aufgabe ist durch die Merkmale des Anspruches 1 oder 10 gelöst. Bevorzugte Weiterbildungen der Erfindung sind in den Unteransprüchen offenbart.

Die Erfindung geht von einem Pulswechselrichter aus, bei dem der Zwischenkreiskondensator und zumindest ein Leistungsmodul an einem Montageträger befestigt sind. Der Zwischenkreiskondensator und das Leistungsmodul sind über Kontaktlaschen miteinander in einer Überlapp-Schweißverbindung, die zum Beispiel in einem Laserschweißprozess erzeugt wird. Das Leistungsmodul ist mit einem Hartverguß-Körper ausgebildet, in dem die Leistungsmodul-Lasche eingegossen ist. Ein derart aufgebauter Pulswechselrichter ist in den folgenden Prozessschritten herstellbar: Zunächst werden in einem Vormontageschritt der Zwischenkreiskondensator und das Leistungsmodul am Montageträger vormontiert. Dann folgt ein Schweißschritt, in dem die einander überlappenden Kontaktlaschen mit einem Niederhalter unter Bildung eines Nullspalts auf einen Gegenhalter pressbar sind und anschließend miteinander verschweißbar sind. Gemäß dem kennzeichnenden Teil des Anspruches 1 wird der Gegenhalter nicht mehr als ein separates Bauteil vorgehalten. Vielmehr ist erfindungsgemäß der Gegenhalter ein materialeinheitlicher und einstückiger Bestandteil des Hartverguß-Körpers. Im Schweißschritt können daher die beiden Kontaktlaschen auf tragendem Hartverguß-Material abgestützt sein, das als Gegenhalter wirkt.

In einer ersten Ausführungsvariante sind die Kondensator-Lasche des Zwischenkreiskondensators und die Leistungsmodul-Lasche unmittelbar in Überlapp-Schweißverbindung. Alternativ dazu können die Kondensator-Lasche des Zwischenkreiskondensators und die Leistungsmodul-Lasche mittels einer Verbindungslasche miteinander in elektrischem Kontakt sind. Die Verbindungslasche ist ein separates Blechteil, das sowohl mit der Kondensator-Lasche des Zwischenkreiskondensators als auch mit der Leistungsmodul-Lasche in Überlapp-Schweißverbindung ist.

In einer technischen Umsetzung ist zudem eine Leiterplatte, insbesondere aus Keramik, mit darauf positionierten Leistungstransistoren in dem Hartverguß-Körper eingegossen. In diesem Fall kann die Leistungsmodul-Lasche einen Laschenfuß aufweisen, der in Kontakt mit einer Leiterbahn der Leiterplatte ist. Der Laschenfuß kann in einen Kontaktschenkel übergehen, der mit einer vom Hartverguß-Material freigelegten Terminalfläche ausgebildet ist. Die Terminalfläche des Kontakt-Schenkels ist in die oben erwähnte Überlapp-Schweißverbindung mit der Kondensator-Lasche bringbar. Ein wesentlicher Kern der Erfindung besteht darin, dass die Leiterplatte nicht unmittelbar in Überlapp-Schweißverbindung mit der zum Zwischenkreiskondensator führenden Lasche ist, sondern von der Überlapp-Schweißverbindung - unter Zwischenlage von Hartverguß-Material - beabstandet ist, wodurch während des Herstellungsprozesses ein Bruch der Leiterplatte aufgrund mechanischer und/oder thermischer Belastung vermieden werden kann.

Die Leiterplatte kann beispielhaft ein Direct Copper Bonding Substrate (DCB) sein, das ein bewährter Standard für Leistungselektronikmodule in Industrie-, Hausgeräte- und Automobilanwendungen ist. DCBs bestehen sowohl aus einem Al₂O₃-Substrat (Aluminiumoxid), welches als Isolierschicht dient, als auch aus Kupferverbindungen.

Erfindungsgemäß können sowohl der Laschenfuß als auch der Laschen-Schenkel der Leistungsmodul-Lasche - mit Ausnahme zumindest seiner Terminalfläche - im Hartverguß-Körper eingegossen sein. In diesem Fall ist daher die von der freigelegten Terminalfläche abgewandte Unterseite des Laschen-Schenkels in unmittelbarer Gießverbindung mit dem tragenden Hartverguß-Material.

Bevorzugt ist es, wenn die Terminalfläche der Leistungsmodul-Lasche nicht flächenbündig mit der Außenkontur des Hartverguß-Körpers abschließt. Eine solche flächenbündige Anordnung der Terminalfläche auf der Außenkontur des Hartverguß-Körpers würde zu einer nicht ausreichenden Kriech-/Luftstrecke führen. Anstelle dessen aufgrund der in den Hartverguß-Körper zurückgesetzten Terminalfläche sind ausreichende Luft-/Kriechstrecken bereitstellbar.

Die Materialaussparung kann von Hartverguß-Seitenwänden begrenzt sein, die vom Boden um die Profiltiefe hochgezogen sind. Zudem kann die Materialaussparung in Richtung Zwischenkreiskondensator ohne hochgezogene Hartverguß-Seitenwand, sondern vielmehr mit einem seitlich offenen Zugangsbereich ausgebildet sein. Durch den Zugangsbereich kann die Kondensatorlasche in die Materialaussparung des Hartverguß-Körpers einragen.

In einer bevorzugten Ausführungsvariante kann, in Leistungsmodul-Dickenrichtung betrachtet, die Leiterplatte in einer unteren Ebene des Hartverguß-Körpers eingegossen sein, während der Laschen-Schenkel höhenversetzt dazu in einer oberen Ebene des Hartverguß-Körpers eingegossen ist. Die Terminalfläche der Leistungsmodul-Lasche und die Leiterplatte können dabei zueinander bevorzugt planparallel ausgerichtet sein. Bei dieser höhenversetzten Anordnung ist Leistungsmodul-Lasche wie folgt realisierbar: So kann der Laschen-Schenkel über einen in Dickenrichtung ausgerichteten Übergangsabschnitt in den Laschenfuß übergehen. In Dickenrichtung betrachtet einander um ein Überlappmaß überdecken. Auf diese Weise kann die Leiterplatte sich möglichst bis zur Randseite des Hartverguß-Körpers erstrecken, wodurch ein Abstand zwischen dem Zwischenkreiskondensator und der Leiterplatte und damit eine Streuinduktivität reduzierbar ist.

Der Hartverguß-Körper kann quaderförmig ausgebildet sein. Das Leistungsmodul kann eine Mehrzahl von Leistungsmodul-Laschen aufweisen, die an derselben Quaderseite des Hartverguß-Körpers angeordnet sind. Auf diese Weise können mehrere Leistungsmodule an den verbleibenden Quaderseiten des Hartverguß-Körpers nebeneinander eng gestapelt werden. Jeder Terminalfläche der Leistungsmodul-Laschen kann eine eigene Materialaussparung im Hartverguß-Körper zugeordnet sein. Die Materialaussparungen können über Hartverguß-Stege voneinander beabstandet sein, die die Hartverguß-Seitenwänden zur Begrenzung der jeweiligen Materialaussparung bilden.

Nachfolgend sind Ausführungsbeispiele der Erfindung anhand der beigefügten Figuren beschrieben. Es zeigen:
- Figuren 1 bis 5: jeweils Ansichten, anhand derer ein erfindungsgemäßer Pulswechselrichter beschrieben ist;
- Figuren 6 bis 9: jeweils Ansichten von Vergleichsbeispielen, die nicht von der Erfindung umfasst sind.

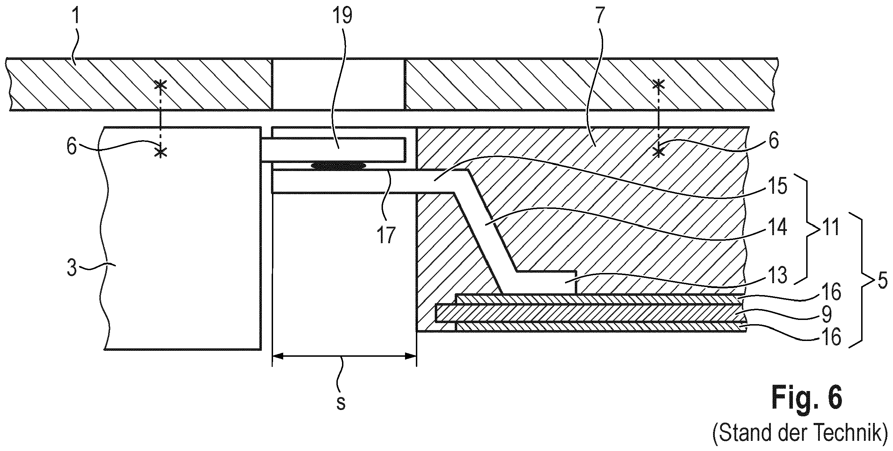

Für ein einfacheres Verständnis der Erfindung wird zunächst Bezug auf das in den Figuren 6 bis 8 gezeigte Vergleichsbeispiel genommen. In der Figur 6 ist ein Pulswechselrichter im Zusammenbauzustand insoweit dargestellt, als es für das Verständnis der Erfindung erforderlich ist. Demnach weist der Pulswechselrichter einen Montageträger 1 auf, an dem ein Zwischenkreiskondensator 3 sowie Leistungsmodule 5 an Schraubstellen 6 verschraubt sind. Von den drei Leistungsmodulen ist in der Figur 11 lediglich ein Leistungsmodul 5 angedeutet. Das in der Figur 6 gezeigte Leistungsmodul 5 ist mit einem Hartverguß-Körper 7 gebildet, in dem eine Leiterplatte 9 aus Keramik, eine Leistungsmodul-Lasche 11 sowie nicht dargestellte Leistungstransistoren eingegossen sind, die auf der Leiterplatte 9 positioniert sind. Die Leistungsmodul-Lasche 11 ist im Querschnitt in etwa Z-förmig mit einem Laschenfuß 13, einem Übergangsabschnitt 14 und einem Laschen-Schenkel 15 ausgebildet. Der Laschenfuß 13 ist in Kontakt mit einer Kupfer-Leiterbahn 16 der Leiterplatte 9; zudem geht der Laschenfuß 13 über den Übergangsabschnitt 14 in den Laschen-Schenkel 15 über. Dieser ragt in der Figur 6 mit einem Überstand s aus einer Schmalseite des quaderförmig ausgebildeten Hartverguß-Körpers 7.

In der Leistungsmodul-Dickenrichtung betrachtet ist die Leiterplatte 9 in einer unteren Ebene des Hartverguß-Körpers 7 eingegossen, während der Laschen-Schenkel 15 höhenversetzt dazu in einer oberen Ebene des Hartverguß-Körpers 7 eingegossen ist. Ferner ist eine nach oben weisende Terminalfläche 17 des Laschen-Schenkels 15 vom Hartverguß freigelegt, die mit einer Kondensator-Lasche 19 des Zwischenkreiskondensators 3 in einer Überlapp-Schweißverbindung ist. An der vom Montageträger 1 abgewandten Unterseite des Leistungsmoduls 5 kann ein nicht dargestellter Kühler vorgesehen sein.

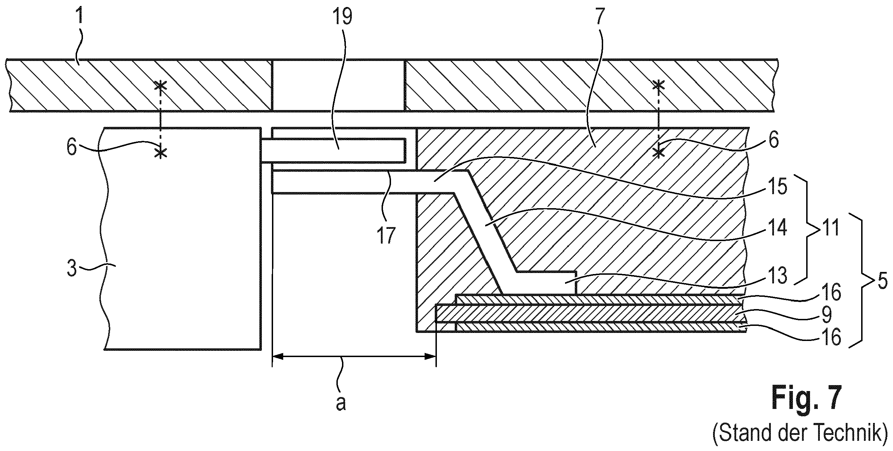

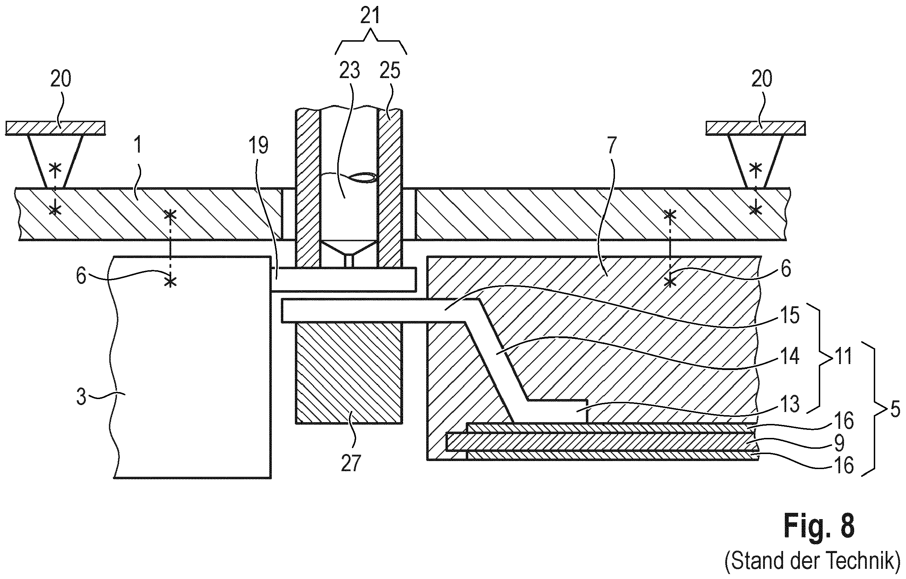

Ein derart aufgebauter Pulswechselrichter ist in den, anhand der Figuren 7 und 8 veranschaulichten Prozessschritten herstellbar: So werden in einem Vormontageschritt (Figur 7) zunächst der Zwischenkreiskondensator 3 und das Leistungsmodul 5 am Montageträger 1 lagerichtig vormontiert. Anschließend wird die in der Figur 7 dargestellte Vormontageeinheit zu einer Schweißstation transferiert, in der der Montageträger 1 an Einspannstellen 20 (Figur 8) ortsfest eingespannt wird.

Bei der Durchführung des Schweißschritts werden die beiden Kontaktlaschen 11, 19 mithilfe eines Laserschweißgerätes 21 miteinander verschweißbar sind. Das Laserschweißgerät 21 ist in der Figur 8 nur grob schematisch angedeutet. Demnach besteht das Laserschweißgerät 21 aus einem Laserschweißkopf 23 sowie aus einem Niederhalter 25 und einem damit zusammenwirkenden Gegenhalter 27. Während des Schweißschrittes werden die beiden einander überlappenden Laschen 11, 19 mit dem Niederhalter 25 unter Bildung eines Nullspalts auf den Gegenhalter 27 gepresst. Anschließend startet der Laserschweißvorgang.

Wie aus den Figur 6 bis 8 hervorgeht, muss zwischen dem Zwischenkreiskondensator 3 und dem Leistungsmodul 5 ein ausreichend großer Werkzeugzugang für den Gegenhalter 27 bereitgestellt werden. Dadurch ergibt sich ein entsprechend großer Abstand a (Figur 7) zwischen dem Zwischenkreiskondensator 3 und der Leiterplatte 9, wodurch Streuinduktivitäten erzeugt werden können. Zudem gestaltet sich der Schweißprozess mit dem als separates Bauteil vorgehaltenen Gegenhalter 27 bauteilaufwändig.

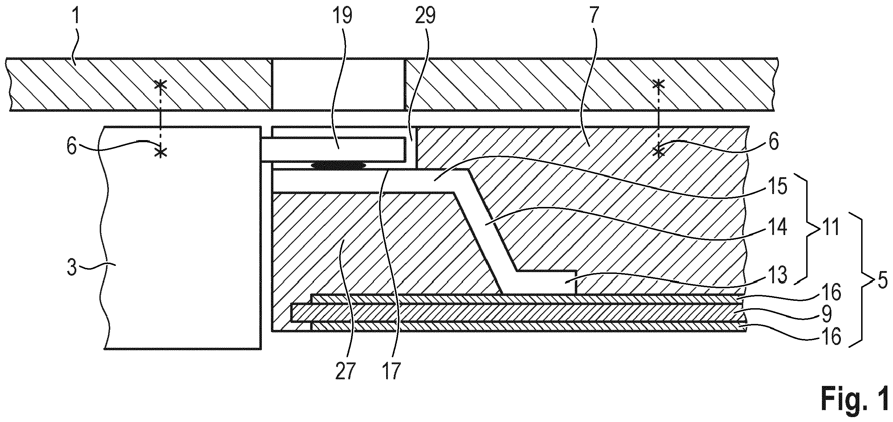

In Abkehr zu dem in den Figuren 6 bis 8 gezeigten Vergleichsbeispiel ist nachfolgend anhand der Figuren 1 bis 5 ein erfindungsgemäßer Pulswechselrichter beschrieben, der im Wesentlichen so wie im Vergleichsbeispiel aufgebaut ist. Von daher wird auf die Vorbeschreibung verwiesen.

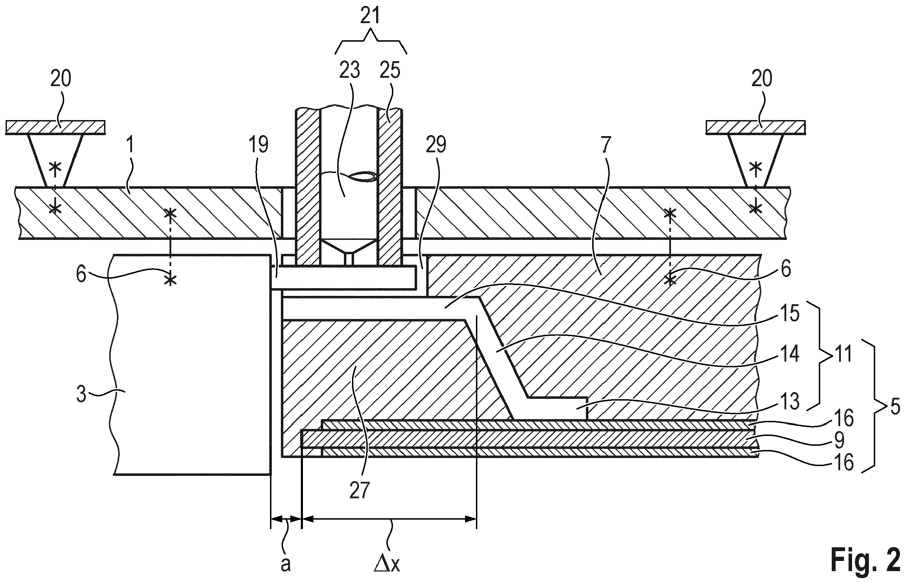

Im Unterschied zum Vergleichsbeispiel der en 6 bis 8 wird erfindungsgemäß auf die Bereitstellung eines separaten Gegenhalter 27 während des Schweißprozesses verzichtet. Anstelle dessen ist in der Figur 1 oder 2 der Gegenhalter 27 ein materialeinheitlicher und einstückiger Bestandteil des Hartverguß-Körpers 7. Während des Schweißschrittes sind daher die beiden Kontaktlaschen 11, 19 unmittelbar auf tragendem Hartverguß-Material abgestützt, das als Gegenhalter 27 wirkt.

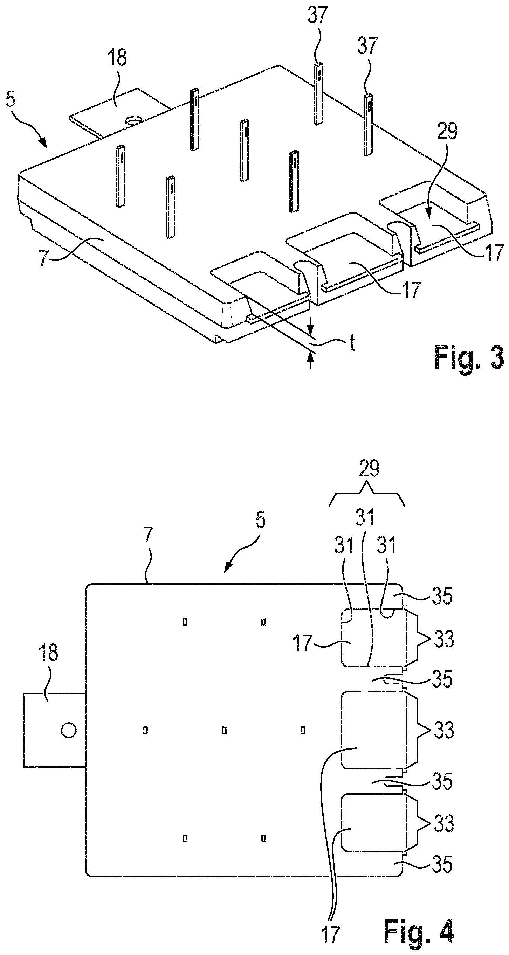

In der Figur 1 oder 2 ist die Terminalfläche 17 der Leistungsmodul-Lasche 11 nicht flächenbündig mit der quaderförmigen Außenkontur des Hartverguß-Körpers 7 ausgerichtet. Vielmehr weist der Hartverguß-Körper 7 eine mit einer Profiltiefe t (Figur 3) von der Außenkontur der Hartverguß-Körpers 7 zurückgesetzte Materialaussparung 29 auf, deren Boden von der Terminalfläche 17 gebildet ist. Die Materialaussparung 29 ist mittels Hartverguß-Seitenwänden 31 (Figur 4) definiert, die vom Boden um die Profiltiefe t hochgezogen sind. Die Materialaussparung 29 ist jedoch in Richtung Zwischenkreiskondensator 3 ohne hochgezogene Hartverguß-Seitenwand 31, sondern vielmehr mit einem offenen Zugangsbereich 33 (Figur 4) ausgebildet, durch den die Kondensator-Lasche 19 in die Materialaussparung 29 einragt. Die Kondensator-Lasche 19 kann daher geometrisch einfach ebenflächig ausgeführt sein, d.h. ohne Winkelprofil, um die Terminalfläche 17 zu kontaktieren.

In den Figuren 3 und 4 ist ein erfindungsgemäßes Leistungsmodul 5 in Alleinstellung gezeigt. Demnach ist der Hartverguß-Körper 7 quaderförmig ausgebildet. Zudem weist das Leistungsmodul 5 auf seiner DC-Seite insgesamt drei Leistungsmodul-Laschen 11 mit darauf ausgebildeten Terminalflächen 17 auf. Diese sind allesamt an derselben Quaderseite des Hartverguß-Körpers 7 angeordnet, so dass mehrere Leistungsmodule 5 an ihren rechtwinklig dazu ausgebildeten Quaderseiten eng nebeneinander stapelbar sind.

Um erforderlich Luft- und Kriechstrecken bereitzustellen, ist in den Figuren 3 und 4 jeder Terminalfläche 17 der Leistungsmodul-Laschen 11 jeweils eine eigene Materialaussparung 29 im Hartverguß-Körper 7 zugeordnet. Die drei Materialaussparungen 29 sind in der Figur 4 über Hartverguß-Stege 35 voneinander beabstandet. Die Hartverguß-Stege 35 bilden jeweils Hartverguß-Seitenwände 31, die die jeweilige Materialaussparung 29 definieren.

Das in der Figur 3 oder 4 gezeigte Leistungsmodul 5 weist auf seiner, der DC-Seite gegenüberliegenden AC-Seite eine AC-Lasche 18 auf, die über eine nicht dargestellte AC-Strombrücke mit der Elektromaschine verbindbar ist. Zudem ragen von der Oberseite des Leistungsmoduls 5 Signalkontakte 37 in Form von Pins nach oben ab. Diese können in Presspassung mit einer nicht dargestellten Steuerplatine des Pulswechselrichters gebracht werden.

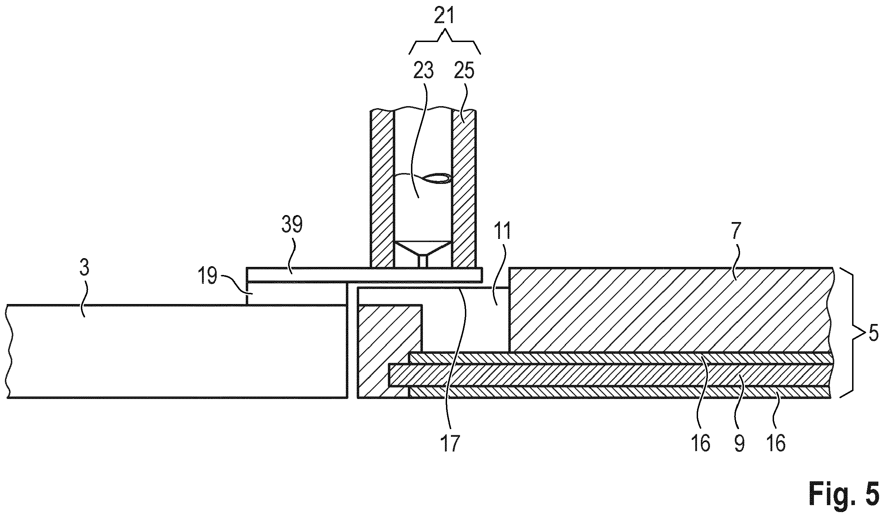

In den Figuren 1 bis 5 sind die Kondensator-Lasche 19 und die Leistungsmodul-Lasche 11 unmittelbar in Überlapp-Schweißverbindung. Im Unterschied dazu ist in der Figur 5 ein Pulswechselrichter gemäß einem zweiten Ausführungsbeispiel gezeigt, bei dem die Kondensator-Lasche 19 des Zwischenkreiskondensators 3 und die Leistungsmodul-Lasche 11 mittels einer Verbindungslasche 39 miteinander in elektrischem Kontakt sind. Die Verbindungslasche 39 ist ein separates Blechteil, das sowohl mit der Kondensator-Lasche 19 des Zwischenkreiskondensators 3 als auch mit der Leistungsmodul-Lasche 11 in Überlapp-Schweißverbindung ist. Gemäß der Figur 5 ist die Kondensator-Lasche 19 auf der Oberseite des Zwischenkreiskondensators 3 positioniert, wodurch die Kondensator-Lasche 19 und die Leistungsmodul-Lasche 11 in Horizontalebene flächenbündig ausgerichtet sind.

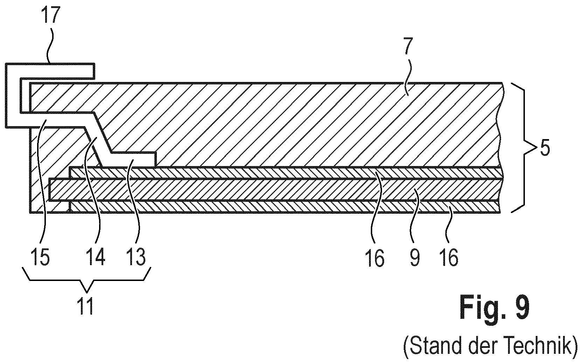

In der Figur 9 ist ein weiteres, nicht von der Erfindung umfasstes Vergleichsbeispiel angedeutet. Das in der Figur 9 gezeigte Vergleichsbeispiel ist ähnlich wie das Vergleichsbeispiel der Figuren 6 bis 8 aufgebaut, und zwar mit dem Unterschied, dass die Leistungsmodul-Lasche 11 mit ihrem freien Überstand s bis auf die Leistungsmodul-Oberseite umgebogen ist. Der Laschen-Schenkel 15 liegt daher lose auf der Oberseite des Hartverguß-Körpers 7. Im Schweißschritt werden die beiden Kontaktlaschen 11, 19 mittels des Niederhalters 25 auf das tragende Hartverguß-Material des Hartverguß-Körpers 7 gepresst, das als Gegenhalter wirkt. Im Unterschied zur Erfindung liegt in der Figur 9 der Laschen-Schenkel 15 der Leistungsmodul-Lasche lose auf der Außenkontur des Hartverguß-Körpers 7 auf. Demgegenüber ist erfindungsgemäß der Laschen-Schenkel 15 so im Hartverguß-Körper 7 eingegossen, dass die von der freigelegten Terminalfläche 17 abgewandte Unterseite des Laschen-Schenkels 15 in Gießverbindung mit dem Hartverguß-Material ist.

### Bezugszeichenliste

- 1: Montageträger
- 3: Zwischenkreiskondensator
- 5: Leistungsmodul
- 6: Schraubstellen
- 7: Hartverguß-Körper
- 9: Leiterplatte
- 11: Leistungsmodul-Lasche
- 13: Laschenfuß
- 14: Übergangsabschnitt
- 15: Laschen-Schenkel
- 17: Terminalfläche
- 18: AC-Lasche
- 19: Kondensator-Lasche
- 20: Einspannstellen
- 21: Laserschweißgerät
- 23: Laserschweißkopf
- 25: Niederhalter
- 27: Gegenhalter
- 29: Materialaussparung
- 31: Hartverguß-Seitenwand
- 33: Zugangsbereich
- 35: Hartverguß-Stege
- 37: Signalkontakte
- 39: Verbindungselement
- Δx: Überstand
- a: Abstand
- s: freier Überstand
- t: Profiltiefe

## Patentansprüche

1. Pulswechselrichter für eine Antriebseinheit eines elektrisch betriebenen Fahrzeugs, mit einem Montageträger (1), an dem ein Zwischenkreiskondensator (3) und zumindest ein Leistungsmodul (5) befestigt sind, die über Laschen (11, 19, 39) in einer Schweißverbindung, insbesondere Überlapp-Schweißverbindung sind, wobei das Leistungsmodul (5) einen Hartverguß-Körper (7) aufweist, in dem die Leistungsmodul-Lasche (11) eingegossen ist, und wobei der Pulswechselrichter in den folgenden Prozessschritten herstellbar ist:
- Vormontageschritt, in dem der Zwischenkreiskondensator (3) und das Leistungsmodul (5) am Montageträger (1) vormontierbar sind,
- Schweißschritt, in dem die Leistungsmodul-Lasche (11) und eine damit überlappende, zum Zwischenkreiskondensator (3) führende Lasche (19, 39) mit einem Niederhalter (25) unter Bildung eines Nullspalts auf einen Gegenhalter (27) pressbar und anschließend miteinander verschweißbar sind, **dadurch gekennzeichnet, dass** der Gegenhalter (27) ein materialeinheitlicher und einstückiger Bestandteil des Hartverguß-Körpers (7) ist, so dass insbesondere im Schweißschritt die einander überlappenden Laschen (11, 19, 39) auf tragendem Hartverguß-Material abstützbar sind, das als Gegenhalter (27) wirkt.

2. Pulswechselrichter nach Anspruch 1, **dadurch gekennzeichnet, dass** eine Leiterplatte (9), insbesondere aus Keramik, mit darauf positionierten Leistungstransistoren in dem Hartverguß-Körper (7) eingegossen ist, und/oder dass insbesondere die Leistungsmodul-Lasche (11) einen Laschenfuß (11) aufweist, der in Kontakt mit einer Leiterbahn (16) der Leiterplatte (9) ist, und dass insbesondere der Laschenfuß (11), bevorzugt über einen Übergangsabschnitt (14), in einen Laschen-Schenkel (15) übergeht, und/oder dass insbesondere der Laschen-Schenkel (15) eine vom Hartverguß-Material des Hartverguß-Körpers (7) freigelegte Terminalfläche (17) aufweist, die in die Überlapp-Schweißverbindung mit der zum Zwischenkreiskondensator (3) führenden Lasche (19, 39) bringbar ist, und/oder dass der Laschen-Schenkel (15) mit darauf ausgebildeter Terminalfläche (17) von der Leiterplatte (9) beabstandet ist, so dass die Niederhaltekraft während des Schweißprozesses nicht unmittelbar auf die Leiterplatte (9) einwirkt.

3. Pulswechselrichter nach Anspruch 2, **dadurch gekennzeichnet, dass** sowohl der Laschenfuß (13) als auch der Laschen-Schenkel (15) mit Ausnahme zumindest seiner Terminalfläche (17) im Hartverguß-Körper (7) eingegossen sind, und dass insbesondere die von der freigelegten Terminalfläche (17) abgewandte Unterseite des Laschen-Schenkels (15) in stoffschlüssiger Gießverbindung mit dem tragenden Hartverguß-Material ist.

4. Pulswechselrichter nach Anspruch 2 oder 3, **dadurch gekennzeichnet, dass** der Hartverguß-Körper (7) eine mit einer Profiltiefe (t) von der Außenkontur des Hartverguß-Körpers (7) zurückgesetzte Materialaussparung (29) aufweist, deren Boden von der Terminalfläche (17) der Leistungsmodul-Lasche (11) gebildet ist.

5. Pulswechselrichter nach Anspruch 4, **dadurch gekennzeichnet, dass** die Materialaussparung (29) von Hartverguß-Seitenwänden (31) definiert ist, die vom Boden um die Profiltiefe (t) hochgezogen sind.

6. Pulswechselrichter nach Anspruch 5, **dadurch gekennzeichnet, dass** die im Hartverguß-Körper (7) ausgebildete Materialaussparung (29) in Richtung Zwischenkreiskondensator (3) ohne hochgezogene Hartverguß-Seitenwand (31), d.h. mit einem seitlich offenen Zugangsbereich (33) ausgebildet ist, durch den die Kondensatorlasche (19) in die Materialaussparung (29) einragt.

7. Pulswechselrichter nach einem der Ansprüche 2 bis 6, **dadurch gekennzeichnet, dass** in Leistungsmodul-Dickenrichtung betrachtet die Leiterplatte (9) in einer unteren Ebene des Hartverguß-Körpers (7) eingegossen ist, und der Laschen-Schenkel (15) höhenversetzt dazu in einer oberen Ebene des Hartverguß-Körpers (7) eingegossen ist.

8. Pulswechselrichter nach einem der Ansprüche 2 bis 7, **dadurch gekennzeichnet, dass** die Terminalfläche (17) der Leistungsmodul-Lasche (11) und die Leiterplatte (9) zueinander planparallel ausgerichtet sind, und/oder dass die Leistungsmodul-Lasche (11) aus dem Laschen-Schenkel (15) besteht, der über einen in Dickenrichtung ausgerichteten Übergangsabschnitt (14) in den Laschenfuß (13) übergeht, und/oder dass in Leistungsmodul-Dickenrichtung betrachtet der mit der Terminalfläche (17) ausgebildete Laschen-Schenkel (15) und die Leiterplatte (9) um ein Überlappmaß (Δx) einander überdecken, wodurch insbesondere der Abstand (a) zwischen dem Zwischenkreiskondensator (3) und der Leiterplatte (9) und damit die Streuinduktivität reduzierbar ist.

9. Pulswechselrichter nach einem der vorhergehenden Ansprüche, **dadurch gekennzeichnet, dass** der Hartverguß-Körper (7) quaderförmig ausgebildet ist, dass insbesondere das Leistungsmodul (5) eine Mehrzahl von Leistungsmodul-Laschen (11) aufweist, die an derselben Quaderseite des Hartverguß-Körpers (7) angeordnet sind, und dass insbesondere jeder Terminalfläche (17) der Leistungsmodul-Laschen (11) eine eigene Materialaussparung (29) im Hartverguß-Körper (7) zugeordnet ist, die über Hartverguß-Stege (35) voneinander beabstandet sind, und dass insbesondere die Hartverguß-Stege (35) die Hartverguß-Seitenwände (31) bilden.

10. Leistungsmodul (5) für einen Pulswechselrichter insbesondere nach einem der vorhergehenden Ansprüche, wobei das Leistungsmodul (5) einen Hartverguß-Körper (7) aufweist, in dem zumindest eine Leistungsmodul-Lasche (11) eingegossen ist, die mit einer zu einem Zwischenkreiskondensator (3) führendenden Lasche (19, 39) in Überlapp-Schweißverbindung bringbar ist, **dadurch gekennzeichnet, dass** die Leistungsmodul-Lasche (11) an ihrer, der Lasche (19, 39) gegenüberliegenden Seite auf einem tragenden Hartverguß-Material des Hartverguß-Körpers (7) abgestützt ist, das im Schweißprozess als Gegenhalter (27) wirkt.
